**Europäisches Patentamt**

**European Patent Office**

**Office européen des brevets**

(11) Publication number: **0 182 077**
**A2**

# (12) EUROPEAN PATENT APPLICATION

(21) Application number: **85112904.9**

(22) Date of filing: **11.10.85**

(51) Int. Cl.⁴: **H01R 23/72**

(30) Priority: **19.11.84 US 672970**

(43) Date of publication of application:
**28.05.86 Bulletin 86/22**

(84) Designated Contracting States:
**DE FR GB**

(71) Applicant: **International Business Machines Corporation**
**Old Orchard Road**
**Armonk, N.Y. 10504(US)**

(72) Inventor: **Buchanan, Morris Edwin**
**649 Beth Lane**
**Lexington Kentucky 40503(US)**
Inventor: **Paulson, Thomas Michael**
**939 Edgewaterdrive**
**Lexington Kentucky 40502(US)**
Inventor: **Starski, Wojeiech**
**1936 Cottonwood Drive**
**Lexington Kentucky 40503(US)**

(74) Representative: **Colas, Alain**
**Compagnie IBM France Département de Propriété**
**Industrielle**
**F-06610 La Gaude(FR)**

(54) **Multi-pin connector suitable for automatic board insertion.**

(57) Disclosed is a multiple pin connector (10) having a comb which embraces the pins (15b) adjacent their terminal ends to maintain parallelism between the pins for ease of insertion into a circuit board. A pair of tubular, solder wettable guide members (24) and (25) having terminal ends which project beyond the terminal ends of the pins (15b), are adapted to engage suitable apertures in a printed circuit board before the pins engage their apertures to effectively guide the pins into their proper location on the circuit board.

# MULTI-PIN CONNECTOR SUITABLE FOR AUTOMATIC BOARD INSERTION

The present invention relates to connectors having multiple pins, and more specifically relates to connectors designed to facilitate multiple pin alignment and insertion into a printed circuit board and the like.

State of the art multiple pin connectors are difficult if not impossible to insert by an automatic machine into suitable apertures in printed circuit boards. This is particularly true of connectors having pins which project from a surface other than the connector surface which lies adjacent the printed circuit board. An example of such a connector is the well known "right-angle" connector where the pins project from the body of the connector substantially parallel to the circuit board, and then bend downwardly parallel to the circuit board, and then bend downwardly at right angles to pass through apertures in the circuit board where the pins are then soldered. When the pins are thus disposed, they are longer than the flush mounted connector surface pinned structures and thus, no matter how carefully handled, exhibit strong tendencies for pin-to-pin misalignment.

Pin-to-pin alignment and proper alignment of the pins to the apertures is mandatory for correct insertion and mounting of the connector to the circuit board. This is true of both manual and automatic connector placement with proper pin insertion. The prior art exhibits means for maintaining single plane pin-to-pin alignment such as shown by MOLEX connector MOLEX part number 7224 (MOLEX catalog 840, pg. 3B, right angle header) which even illustrates plastic studs projecting from the body portion to aid in proper placement of the connector as well as its pins in a circuit board. Although these are excellent connectors they are unsuitable for automatic connector placement in circuit boards. In the first instance, it is difficult, with state of the art pin guides, to achieve pin-to-pin alignment in all planes. Moreover, it is almost impossible to obtain with plastic studs (molded) correct guide to pin alignment. What's more, it is difficult to use such plastic guides or studs in an automated setting because the plastic studs (even if stud-to-pin alignment is within tolerances) will tend to deform, melt down or float (dependent upon material of course) in a hot solder bath which is conventionally employed to solder the pins to the circuit board.

The present invention alleviates these problems by employing a comb which embraces the pins adjacent their terminal ends, the comb being preferably a separate part of the body of the connector and aligned for connection thereto. Spaced apart first and second guide or alignment members project from the body portion of the connector, the comb means maintaining the pins parallel to each other and in alignment with the guide or alignment members.

In order to permit use of the connector in automated assembly machines or the like, the guide or alignment members are composed of a material having physical properties sufficient to inhibit degradation of the members when exposed to the heat of a solder bath. Moreover, by composing the member of a tubular solder-wettable, rivet like stud, the physical attachment of the connector to the circuit board allows handling without inadvertent removal of the connector from the board while facilitating soldering in a solder bath.

Other advantages of the present invention are set forth in the following specification and claims taken in conjunction with the companying drawings.

Fig. 1 is an enlarged side elevational view of a connector illustrating female card edge connections and including apparatus constructed in accordance with the present invention ;

Fig. 2 is a bottom elevational view of the connector of fig. 1 and as if fig. 1 is viewed from the left of rotated 90°;

Fig.3 is a fragmentary side elevational view of the connector of fig. 1 and showing the connector rotated 180°;

Fig.4 is a fragmentary end view of the connector illustrated in figures 1-3 ;

Fig. 5 is a view in plan of the connector shown in figs. 1-4 and mounted on a fragmentary portion of a printed circuit board, and ;

Fig. 6 is a side elevational view of the board and connector of fig. 5, with a portion of the connector and board in fragment to better show the alignment of the pins to the board.

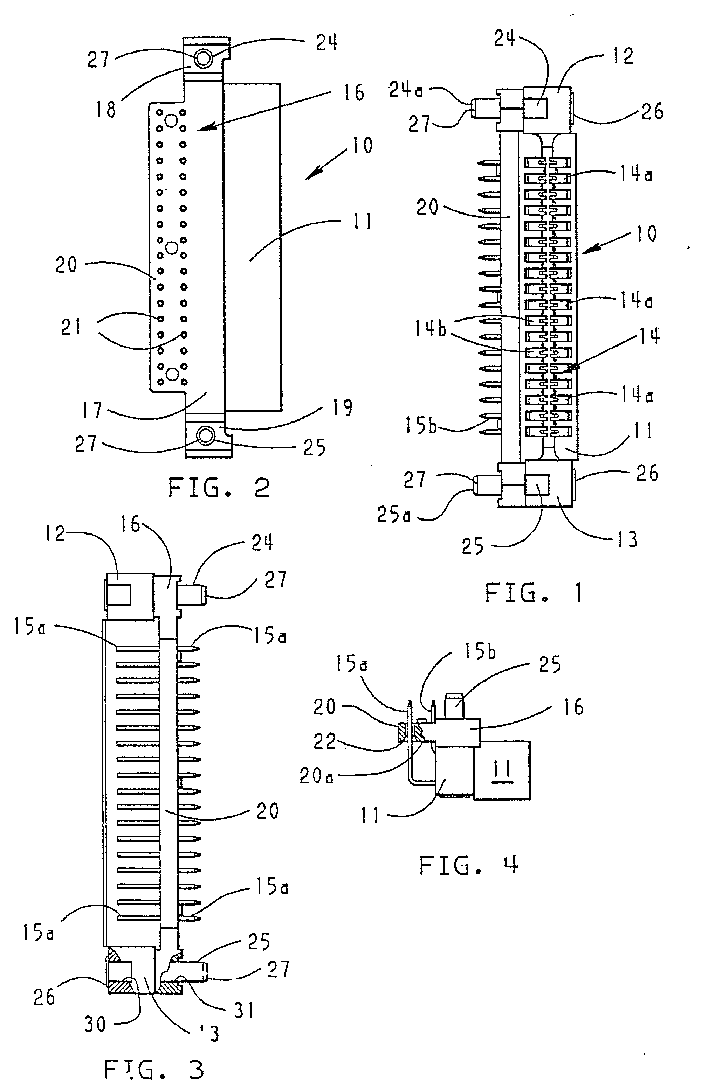

Referring now to the drawing, and especially fig. 1 thereof, a typical connector 10 constructed in accordance with the present invention is illustrated therein. In the illustrated instance, the connector may be referred to as a 36 pin card edge, right angle circuit board connector. At the outset it should be recognized that it is irrelevant how many pins the connector has or whether the connector is adapted to receive a card edge etc. The present invention is easily adaptable to any multiple pin connector for facilitating placement of the connector into a printed circuit board.

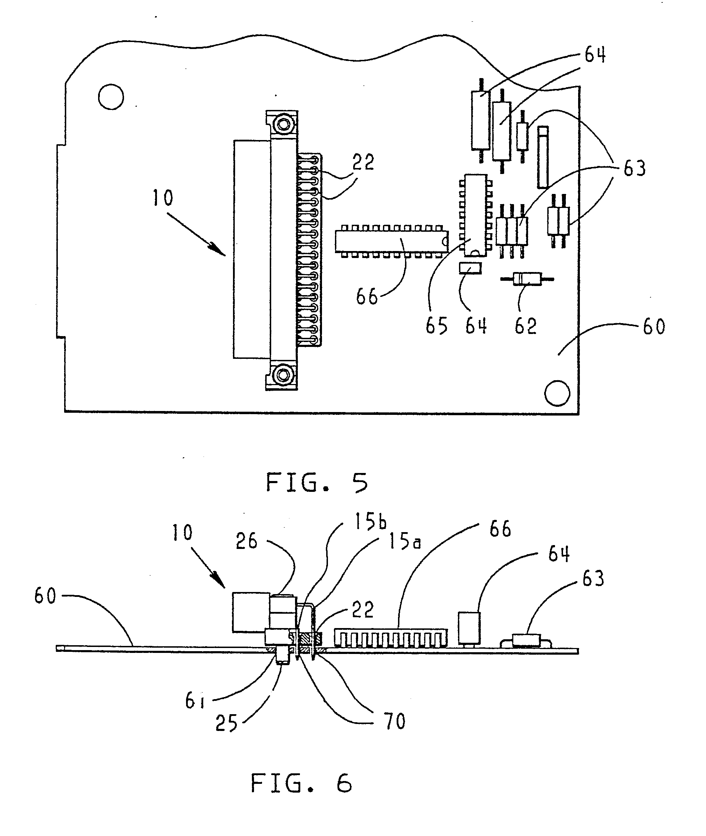

In accordance with the invention, the connector 10 is designed to permit easy insertion thereof into a printed circuit board or the like, such as the board 60 illustrated in fig. 5, without necessitating the straightening of pins to maintain parallelism, one to the other and while facilitating pin-to-board insertion. To this end, the connector 10 includes a body portion 11 and spaced apart laterally extending ears 12 and 13 projecting therefrom. As is conventional, the body portion 11 includes a plurality of confronting contacts 14, in the present instance upper and lower card-edge contacts 14a and 14b respectively, which pass through the body portion 11 of the connector 10. Each contact 14a, 14b is respectively connected to a pin designated 15a, 15b, the upper contacts 14a being connected to the upper pins 15a and the lower contacts 14b being connected to the lower pins 15b (see figs. 1-4). As illustrated best in fig. 4, the pins 15a and 15b are bent at 90° with respect to the contacts 14.

In order to provide proper pin-to-pin relationship of the pins 15a and 15b with respect to each other, comb means 16 is provided. As illustrated, the comb means 16 comprises a planar portion 17 which underlies and registers with the body portion 11 of the connector 10, and ears 18 and 19 which underlie and register with the ears 12 and 13. Inasmuch as the pins 15a and 15b are bent at 90° with respect to the plane of the contacts 14, the planar portion 17 includes a laterally extending offset 20 which is provided with a plurality of apertures 21 therein for embracing the pins 15a and 15b. As illustrated in figs 1, 3 and 4, the apertures 21 in the offset of the comb means 16 capture the pins 15a and 15b adjacent their extended terminal ends. In this manner the correct pin-to-pin relationship is maintained.

Although the comb means 16 is preferably a separate piece, it may be integral with the connector, i.e. formed as one piece simultaneously with the formation of the body portion 11 of the connector 10. Moreover, in its preferred embodiment, the apertures 21, as shown in fig. 4 preferably include a conical recess 22 in the upper surface 20a of the offset 20 to aid in pin insertion into the comb means 16 registering the comb means with the body portion 11. The conical recesses 22 aid in deflecting the pins 15a and 15b through the apertures 21 and through the offset 20.

In order that the aligned and parallel pins 15a and 15b may be easily inserted into printed circuit boards such as the printed circuit board 60 as by automatic machinery and the like, special alignment members are provided on the connector 10 for initial registration in the printed circuit board. To this end, and in accordance with a feature of the present invention, extending from the body portion 11 of the connector 10 are spaced apart first and second guide or alignment members 24 and 25. As shown in figs. 1, 3 and 4, the members 24 and 25 are arranged (as shall be described hereinafter) parallel to the terminal ends of the pins 15a and 15b. Moreover, the members 24 and 25 have terminal ends 24a and 25a which project beyond the terminal ends of the pins 15a and 15b. In this manner, the members 24 and 25 engage properly placed apertures in the circuit board 60 prior to engagement of the terminal ends of the pins 15a and 15b.

The guide or alignment members 24 and 25 are preferably tubular, resembling a rivet, and having an enlarged head end 26 and a remote or distal end portion 27. The distal end portion 27 is frusto-conical or chamfered which aids in alignment of the guide members with like apertures 61 in the printed circuit board 60 (see fig. 6). As best shown in fig. 3, each of the ears 12 and 13 includes a guide hole 30 into which is positioned its associated guide member 24 or 25. Registering with the guide holes 30 are like bore holes 31 located in the ears 18 and 19 of the comb means 16. In the event that the comb means 16 is separate from the body portion 11 of the connector 10 (preferred), at least the bore holes 31 are dimensioned to provide a tight fit with the guide or alignment members 24 and 25. Thus the comb means 16 may be placed over the pins 15a and 15b and then the guide or alignment members 24 and 25 may be passed through the holes 30 and into the tight fitting bore holes 31. In this manner no extra means is necessary to attach the comb means 16 to the body portion 11 of the connector.

Referring now to figs. 5 and 6, a printed board 60 is illustrated therein. As is conventional, the board includes several resistors 62, diodes 63, capacitors 64 and integrated circuit chips 65 and 66 along with other miscellaneous components. All of these components may be inserted into suitably dimensioned apertures in the printed circuit board 60 and the components soldered to the circuit board, as in a solder bath and the like.

Heretofore, unfortunately, it was difficult to insert connectors for soldering into the board 60 unless the connector had few pins and those pins were relatively short. However, with the connector 10, if the apertures 61 in the board 60 are accurately located with respect to the apertures 70 for the pins 15a and 15b, inasmuch as the location of the apertures 21 are located accurately with respect to the guide members 24 and 25, insertion of the connector 10 into the board is insured.

In an automated board handling line, it may be desirable to insure that inadvertent displacement or dislodgement of the connector 10 from the circuit board 60 does not occur in normal handling. Although it is a simple matter to dimension the apertures 61 in the circuit board 60 to insure a tight and embracing fit with the guide members 24 and 25, if desired a flaring tool may be inserted into the terminal end 27 and the end of the guide member flared outwardly to mechanically hold the connector 10 to the circuit board 60. Thereafter, inasmuch as the guide members 24 and 25 are composed of a material which does not degrade under the heat of a solder bath and is preferably solder wettable, the guide members 24 and 25 may be soldered to the board during the conventional wave solder process.

Although the invention has been described with a certain degree of particularity, it is understood that the present disclosure has been made only by way of example and that numerous changes in the details of construction and the combination and arrangement of parts may be made without departing from the spirit and scope of the invention as hereinafter claimed :

**Claims**

1. A connector designed for ease of automatic insertion into a printed circuit board and the like, said connector including a laterally extending body portion having a plurality of pins (15a, 15b) projecting from said body portion, this connector being characterized in that it includes :

first and second guide members (24, 25) extending from said body portion, parallel to said pins and having an extended terminal end projecting beyond the extended terminal ends of the pins;

said body portion including comb means (17) embracing and engaging said pins to maintain said pins parallel to each other and in predetermined alignment with respect to said guide members, said guide members being composed of a material having physical properties sufficient to inhibit degradation of said members when exposed to the heat of a solder bath.

2. A connector in accordance with claim 1 wherein said comb means includes means for guiding said pins through means defining apertures in said comb means.

3. A connector in accordance with claim 2 wherein said means for guiding said pins through said comb means comprise a conically shaped recess in one surface of said comb means, circumscribing each aperture.

4. A connector designed for ease of automatic insertion into a printed circuit board and the like, said connector including a laterally extending body portion having a plurality of pins projecting from said body portion, this connector being characterized in that it includes :

laterally extending ears protruding from said body portion and substantially perpendicular to said pins, first and second guide members extending from said ears, parallel to said pins and having an extended terminal end projecting beyond the extended terminal ends of said pins ;

said body portion including comb means embracing and engaging said pins to maintain said pins parallel to each other and in predetermined alignment with respect to said guide members, said guide members being composed of a material having physical properties sufficient to inhibit degradation of said members when exposed to the heat of a solder bath.

5. A connector in accordance with any one of the preceding claims wherein said guide members are composed of a solder wettable material.

6. A connector in accordance with any one of the preceding claims wherein said terminal ends of said guide members are frusto-conically shaped to aid in alignment of said connector upon insertion of said guide members into suitable apertures in a circuit board.

7. A connector in accordance with any one of the preceding claims wherein said comb means is integral with said body portion of said connector.

8. A connector in accordance with any one of the preceding claims wherein said pins are bent 90° prior to engagement by said comb means ; said guide members being parallel to said portion of said pins engaged by said comb means.

9. A connector in accordance with claim 4 wherein said comb means includes a planar portion with an offset; and laterally spaced apart ears projecting from said planar portion for registration with ears on said body portion.

10. A connector in accordance with claim 9 including apertures in at least said ears of said comb means, said apertures being dimensioned to frictionally engage said guide members to hold said comb means with respect to said body portion.

11. A connector in accordance with any one of the preceding claims wherein said guide members are tubular having an enlarged head end and a chamferred distal end.

FIG. 2

FIG. 1

FIG. 3

FIG. 4

FIG. 5

FIG. 6